# EUROPEAN PATENT SPECIFICATION

(11) **EP 3 043 354 B1**
(45) Date of publication and mention of the grant of the patent: **03.01.2018**
(21) Application number: 15150720.9
(22) Date of filing: 12.01.2015
(51) Int. Cl.: H01B 1/22, H01L 31/0224, H01L 31/05, C09J 9/02

(54) **Use of an electrically conductive composition as an electrically conductive adhesive for mechanically and electrically connecting electrical conductors to electrical contacts of solar cells**
Verwendung einer elektrisch leitenden Zusammensetzung als elektrisch leitenden Klebstoff zur mechanischen und elektrischen Verbindung elektrischer Leiter mit elektrischen Kontakten von Solarzellen
Utilisation d'une composition électriquement conductrice comme adhésif électriquement conducteur destiné à connecter mécaniquement et électriquement des conducteurs électriques à des contacts électriques de cellules solaires

(43) Date of publication of application: 13.07.2016
(73) Proprietor: Heraeus Deutschland GmbH & Co. KG, 63450 Hanau (DE)
(72) Inventor: Hanselmann, Daniel, 63751 Gelnhausen (DE); Dickel, Tanja, 63543 Neuberg (DE); Brand, Alexander, 63820 Elsenfeld (DE); Fritzsche, Sebastian, 63454 Hanau (DE); Koenig, Markus, 64807 Dieburg (DE)
(74) Representative: Heraeus IP

(56) References cited:
- EP-A1- 0 653 763
- EP-A1- 2 058 868
- WO-A1-2014/159792
- WO-A1-2014/169728
- US-A- 5 057 245
- US-A1- 2010 209 690
- US-A1- 2014 374 671

## Description

The invention relates to the use of an electrically conductive composition as an electrically conductive adhesive for mechanically and electrically connecting electrical conductors to electrical contacts of solar cells.

Solar cells can convert light, such as sunlight, into electrical energy. It is possible to collect the electrical energy from one single solar cell. In order to increase the voltage delivered by individual solar cells to a suitable level, a plurality of solar cells is conventionally electrically connected together in series to form an array of solar cells which can be incorporated into a photovoltaic module. Collection of the electrical energy and electrical connection of solar cells is typically made via electrical conductors which are mechanically and at the same time electrically connected to the emitter and collector contacts of the solar cells. The mechanical and at the same time electrical connection of the electrical conductors to the cell contacts is typically made by soldering or by adhesive bonding, in the latter case making use of an electrically conductive adhesive.

The term "electrical conductor" used herein means conventional electrical conductors like, for example, conventional wire, tape, ribbon or conductive backsheet foil (back contacting foil).

The term "emitter contact" used herein means an electrical contact connecting the emitter of a solar cell to an electrical conductor, whereas the term "collector contact" used herein means an electrical contact connecting the collector of a solar cell to an electrical conductor. The electrical contacts take the form of metallizations.

In most of today's photovoltaic modules, the solar cells have emitter contacts and collector contacts located on opposite sides of the cells. The emitter contacts are located on the front surface, i.e. the surface exposed to the sunlight, whereas the collector contacts are on the back side. An example are H-type cells, typically having two emitter contacts known as emitter busbars on their frontface and two collector contacts also known as collector busbars on their backface. A skilled person will recognize that emitter contacts and collector contacts are of opposite polarity.

New cell types have been developed in which the emitter contacts have been moved from the front face to the back face of the solar cell in order to free up an additional portion of front surface and increase the amount of electrical energy that can be produced by the cell. Such solar cells, in which both emitter and collector contacts are located on the back side of the cell, are known under the common designation "back-contact cells", which designation includes metallization wrap-through (MWT) cells, back-junction (BJ) cells, integrated back-contact (IBC) cells and emitter wrap-through (EWT) cells. In the case of these back-contact cells, the emitter contacts are the so-called "vias", or "back emitter contacts", located on the backface of the cells, while the collector contacts are also located there.

Most of today's solar cells are silicon solar cells.

EP 2 058 868 A1 discloses a conductive adhesive film for electrical connection between photovoltaic cell surface electrodes and wiring members, which comprises an insulating adhesive and conductive particles.

US 2010/209690 A1 discloses electrically conductive, thermosetting compositions for use in surfacing films and adhesives. Disclosed are adhesive films and hot melt adhesives.

US 5 057 245 A discloses thermally curable polymer thick film compositions comprising, by weight: (a) about 3-15 parts of at least one poly(hydroxystyrene) resin; (b) a crosslinking resin selected from the group consisting of: (i) about 5-25 parts of at least one blocked isocyanate resin; or (ii) about 2-10 parts of at least one melamineformaldehyde resin; (c) an effective amount of at least one organic solvent capable of substantially dissolving (a) and (b) ingredients; (d) conductive particulate matter selected from the group consisting of: (i) about 50-80 parts silver flake; (ii) a graphite/carbon black mixture consisting of: (aa) about 15-45 parts graphite; and (bb) about 1-10 parts carbon black; or (iii) a mixture of (i) and (ii).

US 2014/374671 A1 discloses a conductive ink including a conductive material, a thermoplastic binder including a polyvinylbutyral terpolymer and a polyvinylpyrrolidone, and a solvent. The conductive material may be a conductive particulate having an average size of from about 0.5 to about 10 microns and an aspect ratio of at least about 3 to 1, such as a silver flake.

Conventional electrically conductive adhesives comprise a huge portion of silver particles with an order of magnitude of about 80 wt.-% (weight-%). Because of the high silver price so-called low-silver alternatives have been developed in terms of replacing a considerable portion of the silver particles by silver-coated particles, for example, silver-coated copper particles. However, there are concerns to use such type of copper containing electrically conductive adhesive for the adhesive bonding of electrical conductors to solar cell contacts, in particular in the case of silicon solar cells. The reasoning is that solar cells are intended for long-term use which enlarges the risk that during a solar cell's service life copper diffuses into the solar cell bulk material and hence forms undesired efficiency reducing recombination centers or even destroys the p-n or n-p transition of the solar cell. This is in particular a concern in the case of silicon solar cells. However, said concerns do not only apply in case of copper but also in case of other elements having a similar effect like copper. Examples of such elements include phosphorus, titanium, vanadium, chromium, manganese, iron, cobalt, nickel, zirconium, niobium, molybdenum, tantalum and tungsten, see "Energy research Centre of the Netherlands, Gianluca Coletti, Sensitivity of crystalline silicon solar cells to metal impurities, September 14, 2011" or "J.R. Davis in IEEE Trans El. Dev. ED-27, 677 (1980)".

The invention prevents said risk by using a specific electrically conductive low-silver type adhesive for mechanically and at the same time electrically connecting the contacts of a solar cell with electrical conductors. In an embodiment, the elements copper, phosphorus, titanium, vanadium, chromium, manganese, iron, cobalt, nickel, zirconium, niobium, molybdenum, tantalum, aluminum and tungsten in elemental or metal form or in the form of an alloy are essentially or completely avoided in the electrically conductive adhesive.

Hence, the invention relates to the use of an electrically conductive composition as an electrically conductive adhesive for mechanically and at the same time electrically connecting at least one contact of a solar cell, preferably a silicon solar cell, with an electrical conductor, wherein said at least one contact is selected from the group consisting of emitter contacts and collector contacts, characterized in that the electrically conductive composition comprises
(A) 2 to 35 vol.-% (volume-%) of silver particles having an average particle size in the range of 1 to 25 µm and exhibiting an aspect ratio in the range of 5 to 30 : 1,
(B) 10 to 63 vol.-% of non-metallic particles having an average particle size in the range of 1 to 25 µm, exhibiting an aspect ratio in the range of 1 to 3 : 1,
(C) 30 to 80 vol.-% of a curable (hardenable, crosslinkable) resin system, and
(D) 0 to 10 vol.-% of at least one additive,
wherein the sum of the vol.-% of particles (A) and (B) totals 25 to 65 vol.-%,
wherein the viscosity of the electrically conductive composition is in the range of 4 to 45 Pa·s measured in accordance with DIN 53018 (at 23 °C, CSR-measurement, cone-plate system, shear rate of 50 rounds per second),
wherein the electrically conductive composition is applied to the contact surface of the at least one contact of the solar cell and/or to the contact surface of the electrical conductor to be adhesively bonded to the at least one contact of the solar cell,
wherein the application of the electrically conductive composition is performed by printing, jetting or dispensing, and
wherein average particle size means the mean primary particle diameter (d50) determined by means of laser diffraction.

In the description and the claims the term "solar cell" is used. It shall not mean any limitation as to a certain type of solar cell. It includes any type of solar cell including in particular silicon solar cells. The cells may be of the afore mentioned H- or back-contact cell type, for example.

In an embodiment, the sum of the vol.-% of (A), (B), (C) and, if present, (D) may total 100 vol.-% of the electrically conductive composition.

The vol.-% disclosed in the description and the claims refer to the electrically conductive composition, i.e. not yet cured, or, to be even more precise, to the electrically conductive composition prior to its application or use according to the invention.

In the description and the claims the term "average particle size" is used. It shall mean the mean primary particle diameter (d₅₀) determined by means of laser diffraction. Laser diffraction measurements can be carried out making use of a particle size analyzer, for example, a Mastersizer 3000 from Malvern Instruments.

In the description and the claims the term "aspect ratio" is used with regard to the shape of the particles (A) and (B) included in the electrically conductive composition. The aspect ratio means the ratio of the largest dimension to the smallest dimension of a particle and it is determined by SEM (scanning electron microscopy) and evaluating the electron microscopical images by measuring the dimensions of a statistically meaningful number of individual particles.

The electrically conductive composition comprises 2 to 35 vol.-%, preferably 2 to 30 vol.-% and most preferably 2 to 20 vol.-% of silver particles (A) having an average particle size in the range of 1 to 25 µm, preferably 1 to 20 µm, most preferably 1 to 15 µm and exhibiting an aspect ratio in the range of 5 to 30 : 1, preferably 6 to 20 : 1, most preferably 7 to 15 : 1. The silver particles (A) may have a coating comprising at least one organic compound, in particular a C8 to C22 fatty acid or derivative thereof like salts or esters. The vol.-% values include the volume contribution of said coatings on the silver particles (A).

The silver particles (A) include particles of silver and silver alloys; i.e. the term "silver particles" used herein shall mean particles of pure silver and/or of silver alloy. In case of silver alloy the total proportion of alloying metals is, for example, >0 to 5 wt.-%, preferably >0 to 1 wt.-%. The silver alloys may comprise binary alloys of silver and one other metal or alloys of silver with more than one metal other than silver. Examples of metals which can be used as alloying metals for the silver include in particular zinc, rhodium, palladium, indium, tin, antimony, rhenium, osmium, iridium, platinum, gold, lead and bismuth. In an embodiment, copper, phosphorus, titanium, vanadium, chromium, manganese, iron, cobalt, nickel, zirconium, niobium, molybdenum, tantalum, aluminum and tungsten are excluded as alloying elements.

The silver particles (A) exhibit an aspect ratio in the range of 5 to 30 : 1, preferably 6 to 20 : 1, most preferably 7 to 15 : 1. Said aspect ratio shall express that the silver particles (A) are, for example, acicular particles (needles) or flakes (platelets) as opposed to, for example, particles having a spherical, an essentially spherical, an elliptical or an ovoid shape.

The electrically conductive composition may comprise one type of silver particles (A) or a combination of two or more different types of silver particles (A). In any case, all types of silver particles (A) contained in the electrically conductive composition meet the afore mentioned average particle size and aspect ratio conditions. To illustrate this, the following theoretical example may be envisaged: An electrically conductive composition may comprise two different types of silver particles as the only particles (A), namely X vol.-% of silver particles having a d50 value of x µm and an aspect ratio of y : 1, and Y vol.-% of silver particles having a d50 value of v µm and an aspect ratio of w : 1, with X+Y lying in said 2 to 35 vol.-% range, x and v independently lying in said 1 to 25 µm range and y and w independently lying in said 5 to 30 : 1 range.

Silver particles of type (A) are commercially available. Examples of such silver particles include SF-3, SF-3J from Ames Goldsmith; Silver Flake #80 from Ferro; RA-0101, AA-192N from Metalor.

In an embodiment, the electrically conductive composition may comprise a portion, for example, 10 to 30 vol.-% of silver particles other than those of type (A), in particular, silver particles having an aspect ratio in the range of, for example, 1 to < 5 : 1 or 1 to 3 : 1. One commercially available example of such silver particles is FA-3162 from Metalor.

The electrically conductive composition comprises 10 to 63 vol.-%, preferably 15 to 63 vol.-% and most preferably 15 to 60 vol.-% of non-metallic particles (B) having an average particle size in the range of 1 to 25 µm, preferably 1 to 20 µm, most preferably 1 to 15 µm and exhibiting an aspect ratio in the range of 1 to 3 : 1, preferably 1 to 2 : 1, most preferably 1 to 1.5 : 1. Examples of useful particles of the (B) type include graphite particles and electrically non-conductive non-metallic particles, in each case meeting said average particle size and aspect ratio conditions. The term "electrically non-conductive non-metallic particles" used herein shall mean non-metallic particles of a material having an electrical conductivity of < 10⁻⁵ S/m. Examples of such materials include glass, ceramics, plastics, diamond, boron nitride, silicon dioxide, silicon nitride, silicon carbide, aluminosilicate, aluminum oxide, aluminum nitride, zirconium oxide and titanium dioxide.

The non-metallic particles (B) exhibit an aspect ratio in the range of 1 to 3 : 1, preferably 1 to 2 : 1, most preferably 1 to 1.5 : 1. Said aspect ratio shall express that the particles (B) have a true spherical or essentially spherical shape as opposed to particles like, for example, acicular particles or flakes. The individual particles (B) when looked at under an electron microscope have a ball like or near-to-ball like shape, i.e., they may be perfectly round or almost round, elliptical or they may have an ovoid shape.

The electrically conductive composition may comprise one type of particles (B) or a combination of two or more different types of particles (B). In any case, all types of particles (B) contained in the electrically conductive composition meet the afore mentioned average particle size and aspect ratio conditions.

Particles of type (B) are commercially available. Examples include AE9104 from Admatechs; EDM99,5 from AMG Mining; CL4400, CL3000SG from Almatis; Glass Spheres from Sigma Aldrich; Spheromers® CA6, CA10, CA15 from Microbeads®.

In a preferred embodiment, the silver particles (A) have an average particle size in the range of 0.2 to 2 times the average particle size of the non-metallic particles (B).

The sum of the vol.-% of silver particles (A) and non-metallic particles (B) totals 25 to 65 vol.-%.

The electrically conductive composition comprises 30 to 80 vol.-%, preferably 30 to 75 vol.-% and most preferably 30 to 70 vol.-% of a curable resin system (C).

The curable resin system (C) comprises those constituents of the electrically conductive composition which after the application and curing thereof form a covalently crosslinked polymer matrix in which the (A) and (B) particles are embedded.

"Curable resin system" means a resin system comprising at least one self-crosslinkable resin, typically, in combination with a starter or initiator, and/or one or more crosslinkable resins in combination with one or more hardeners (crosslinkers, curing agents) for the one or more crosslinkable resins. However, the presence of non-reactive resins within such curable resin system is also possible. To avoid misunderstandings, the term "resin system", although generally understood as referring to polymeric materials, shall not be understood as excluding the optional presence of oligomeric materials. Oligomeric materials may include reactive thinners (reactive diluents). The border between oligomeric and polymeric materials is defined by the weight average molar mass determined by gel permeation chromatography (GPC; divinylbenzene-crosslinked polystyrene as the immobile phase, tetrahydrofuran as the liquid phase, polystyrene standards). Oligomeric materials have a weight average molar mass of ≤ 500, while the weight average molar mass of polymeric materials is > 500.

Typically, the constituents of the curable resin system (C) are non-volatile; however, volatile compounds which can be involved in the curing mechanism of the curable resin system may also be present.

The curable resin system (C) is curable by formation of covalent bonds. Covalent bond forming curing reactions may be free-radical polymerization, condensation and/or addition reactions, wherein condensation reactions are less preferred.

As has already been mentioned before, the curable resin system (C) comprises those constituents of the electrically conductive composition which after the application and curing thereof form a covalently crosslinked polymer matrix or polymer network. This polymer matrix may be of any type, i.e. it may comprise one or more polymers or one or more hybrids of two or more different polymers. Examples of possible polymers may include (meth)acryl copolymers, polyesters, polyurethanes, polysiloxanes, polyethers, epoxy-amine-polyadducts and any combinations. The polymers forming said polymer matrix can stem from polymeric components of the curable resin system (C) and/or can be formed during polymer forming curing reactions of the curable resin system (C) after application and during curing of the electrically conductive composition.

Hence, the one or more resins which may be constituents of the curable resin system (C) may be selected from, for example, (meth)acryl copolymer resins, polyester resins, polyurethane resins, polysiloxane resins, polyether resins including epoxy resin type polyether resins, epoxy-amine-polyadducts and hybrids thereof.

Self-crosslinkable resins of the curable resin system (C) may be resins carrying functional groups capable of reacting among themselves under formation of covalent bonds in the sense of crosslinked network formation. In the alternative, self-crosslinkable resins are resins carrying different functional groups (F1) and (F2) in one and the same molecule, wherein the functional groups (F2) exhibit a reactive functionality complementary to the functionality of the functional groups (F1). The combination of a crosslinkable resin with a hardener means that the crosslinkable resin carries functional groups (F1), while the hardener carries other functional groups (F2) exhibiting a reactive functionality complementary to the functionality of the functional groups (F1). Examples of such complementary functionalities (F1)/(F2) are: carboxyl/epoxy, hydroxyl/isocyanate, epoxy/amine, free-radically polymerizable olefinic double bond/free-radically polymerizable olefinic double bond and the like. The reaction of the complementary functionalities (F1)/(F2) leads in any case to the formation of covalent bonds with the result of formation of a covalently crosslinked polymer network.

In a preferred embodiment, the curable resin system (C) comprises a self-crosslinkable epoxy resin or a system of epoxy resin and hardener for the epoxy resin selected among polyamine hardeners, polycarboxylic acid hardeners and polycarboxylic acid anhydride hardeners. The system of epoxy resin and polyamine hardener for the epoxy resin may optionally comprise lactone.

A curable resin system (C) comprising a self-crosslinkable epoxy resin may comprise a starter or an initiator. It may be a cationically curable system. To initiate cationic cure it requires a cationic initiator, which may be thermo- or UV-labile. Hence a cationically curable resin system (C) comprising a self-crosslinkable epoxy resin may be a thermally curable or a UV-curable resin system.

Examples of useful epoxy resins are bisphenol A and/or bisphenol F epoxy resins, novolac epoxy resins, aliphatic epoxy resins and cycloaliphatic epoxy resins. Examples of such commercially available epoxy resins include Araldite® GY 279, Araldite® GY 891, Araldite® PY 302-2, Araldite® PY 3483, Araldite® GY 281 and Quatrex® 1010 from Huntsman; D.E.R.™ 331, D.E.R.™ 732, D.E.R.™ 354 and D.E.N™ 431 from Dow Chemical; JER YX8000 from Mitsubishi Chemical; and EPONEX™ Resin 1510 from Momentive Specialty Chemicals.

Examples of useful polyamine hardeners are compounds comprising more than one primary or secondary amino group per molecule. Typical examples are diamines, triamines and other polyamines with at least two amino groups in the molecule, wherein the amino groups are selected among primary and secondary amino groups. Secondary amino groups can be present as lateral or terminal functional groups or as member of a heterocyclic ring. Examples of preferred polyamine hardeners include diethylenetriamine, ethylenediamine, triethylenetetramine, aminoethylpiperazine and Jeffamine® D230 from Huntsman.

Examples of useful polycarboxylic acid hardeners include methylhexahydrophthalic acid and their possible anhydrides.

An example of a useful cationic initiator is 1-(p-methoxybenzyl) tetrahydrothiophenium hexafluoroantimonate.

Examples of useful lactones are delta-valerolactone, delta-hexalactone, delta-nonalactone, delta-decalactone, delta-undecalactone, gamma-butyrolactone, gamma-hexalactone, gamma-heptalactone, gamma-octalactone, epsilon-caprolactone, epsilon-octalactone, epsilon-nonalactone and mixtures thereof.

The electrically conductive composition comprises 0 to 10 vol.-% of at least one additive (D).

Examples of additives include 4-cyclohexanedimethanol divinylether; organic solvents, for example, isopropanol, n-propanol, terpineol; wetting agents, for example, oleic acid; rheological modifiers, for example, nanosized silica, ethylcellulose.

So far the composition of the electrically conductive composition has been looked at vol.-%-wise. In an embodiment, the electrically conductive composition comprises 15 to 60 wt.-% of the silver particles (A), 10 to 75 wt.-% of the non-metallic particles (B), 7 to 35 wt.-% of the curable resin system (C), and (D) 0 to 5 wt.-% of the at least one additive, wherein the sum of the wt.-% of (A) and (B) totals 60 to 93 wt.-% and wherein the sum of the wt.-% of (A), (B), (C) and, if present, (D) may total 100 wt.-% of the electrically conductive composition. The wt.-% disclosed in the description and the claims refer to the electrically conductive composition, i.e. not yet cured, or to be even more precise, to the electrically conductive composition prior to its use according to the invention.

The viscosity of the electrically conductive composition is in the range of 4 to 45 Pa·s, most preferably 8 to 35 Pa·s, measured in accordance with DIN 53018 (at 23 °C, CSR-measurement, cone-plate system, shear rate of 50 rounds per second).

The electrically conductive composition can be made by mixing components (A), (B), (C) and, optionally, (D), wherein it is preferred to introduce component (C) first before adding components (A and (B). After completion of the mixing the so-produced electrically conductive composition can be stored until its use according to the invention. It may be advantageous to store the electrically conductive composition at low temperatures of, for example, -78 to +8 °C.

Dependent on the chemical nature of the (C) component and if desired or expedient, it is also possible to split component (C) into sub-components, for example, into a curable resin sub-component (C1) and a hardener sub-component (C2) and to mix (A), (B), (C1) and, optionally, (D) and store that mixture separately from (C2). In so doing a two-component type of the electrically conductive composition is obtained. Its two components are stored separately from each other until the electrically conductive composition is used according to the invention. The two components are then mixed shortly or immediately before the application.

The electrically conductive composition is used according to the invention, i.e. it is used as an electrically conductive adhesive for mechanically and - at the same time - electrically connecting at least one contact of a solar cell with an electrical conductor, wherein the at least one contact is selected from the group consisting of solar cell emitter contacts and solar cell collector contacts.

To this end, the electrically conductive composition is applied to the contact surface of the at least one contact of the solar cell and/or to the contact surface of the electrical conductor to be adhesively bonded to the at least one contact of the solar cell. Typically, the contact surface of a solar cell's contact is a metallization as has already been afore mentioned in the paragraph explaining emitter and collector contacts. The contact surface of an electrical conductor may be a terminal and/or other suitable place of a wire, tape or ribbon. In case of an electrical conductor in the form of a conductive backsheet foil the contact surface thereof is typically in the form of a pattern designed to fit the at least one contact of the solar cell.

Application of the electrically conductive composition is performed by printing, e.g. screen printing or stencil printing, by jetting or by dispensing. The typical thickness of the applied and uncured electrically conductive composition lies in the range of, for example, 20 to 500 µm.

After the application of the electrically conductive composition the one or more solar cell contacts and the electrical conductor(s) to be adhesively bonded thereto are put together with their contact surfaces having the electrically conductive composition in between.

Before the curing, i.e. after the application and prior to or after putting together the one or more solar cell contacts and the electrical conductor(s), an optional drying step may be performed in order to remove eventually present volatile compounds like, for example, organic solvent, from the electrically conductive composition. If such drying step is performed, the drying parameters are for example, 1 to 120 minutes at an object temperature of, for example, 60 to 160 °C.

The so formed assembly comprising the electrically conductive composition is then cured, i.e. the electrically conductive composition is cured. Curing may be initiated by UV irradiation if at least one of the contact surfaces to be adhesively bonded is sufficiently transparent for UV-light and/or allows sufficient access of UV-light and if the curing chemistry of the (C) system allows for an UV curing. Examples of UV-curable (C) systems are the already mentioned curable resin system (C) comprising a self-crosslinkable epoxy resin and a UV-labile cationic initiator or a curable resin system (C) comprising free-radically polymerizable components and a UV-labile free-radical initiator. In the more common alternative of thermal curing heat is applied and the assembly including the electrically conductive composition is heated, for example, for 5 to 30 minutes at an object temperature of, for example, 80 to 160 °C. Thermal curing may be performed in a separate step or it may take place in the course of assembling and consolidating a photovoltaic module or photovoltaic stack as will be disclosed below in more detail.

In the hardened state the electrically conductive composition is solid.

After completion of the curing the solar cell with the electrical conductors attached to its contacts or the array of solar cells connected to each other by electrical conductors may be used for the production of electrical energy, or, in particular, it may be incorporated into a conventional photovoltaic module. To this end, a photovoltaic stack or photovoltaic module may be assembled, for example, by placing a conventional back encapsulant layer on a conventional back sheet, placing the solar cell or the array of solar cells on top of the back encapsulant layer, placing a conventional front encapsulant layer on top of the one or more solar cells and then placing a conventional front sheet on top of the front encapsulant layer. Typically, a so-assembled photovoltaic stack is then consolidated in a laminating device by heating the stack and subjecting the heated photovoltaic stack to a mechanical pressure in a direction perpendicular to the plane of the stack and decreasing the ambient pressure in the laminating device. The heating allows the front and back encapsulants to soften, flow around and adhere to the one or more solar cells and, if not yet performed, to thermally cure the electrically conductive composition; i.e. in the latter case the thermal curing takes place during the consolidation of the photovoltaic stack. Finally the photovoltaic stack is cooled to ambient temperature and the mechanical pressure is released and atmospheric pressure is reestablished in the laminating device.

### Examples

### Example 1a (Preparation of an electrically conductive composition):

A mixture of components of type (C) and (D) was made by mixing 69 pbw (parts by weight) of Araldite® PY 302-2 from Huntsman, 4 pbw of 1-(p-methoxybenzyl) tetrahydrothiophenium hexafluoroantimonate, 21 pbw Araldite® DY-E (reactive diluent) from Huntsman, and 6 pbw of oleic acid.

13 vol.-% (40 wt.-%) of AA-192N from Metalor (particles of (A) type), 31 vol.-% (40 wt.-%) of AE9104 from Admatechs (particles of (B) type) and 56 vol.-% (20 wt.-%) of the mixture of components of type (C) and (D) were mixed. Mixing was performed by introducing the mixture of components (C) and (D) into a beaker and then mixing with the further components by means of a spatula, followed by mixing with a paddle mixer at 300 to 400 U/min for 5 min. Thereafter, the mixtures were milled twice in a triple roll mill at 21 °C, followed by evacuation at less than 10 mbar under stirring with a paddle mixer for 20 min.

### Example 1b (Preparation of an electrically conductive composition):

A mixture of components of type (C) and (D) was made by mixing 63 pbw of D.E.R.™ 732 from Dow Chemical, 8 pbw of Curezol® C2E4MZ hardener from Shikoku, 23 pbw Araldite® DY-E from Huntsman, 4 pbw of 4-cyclohexanedimethanol divinylether and 2 pbw of oleic acid.

17 vol.-% (50 wt.-%) of SF-3J from Ames Goldsmith (particles of (A) type), 24 vol.-% (30 wt.-%) of CL3000SG from Almatis (particles of (B) type) and 59 vol.-% (20 wt.-%) of the mixture of components of type (C) and (D) were mixed. Mixing was performed by introducing the mixture of components (C) and (D) into a beaker and then mixing with the further components by means of a spatula, followed by mixing with a paddle mixer at 300 to 400 U/min for 5 min. Thereafter, the mixtures were milled twice in a triple roll mill at 21 °C, followed by evacuation at less than 10 mbar under stirring with a paddle mixer for 20 min.

### Example 1c (Preparation of an electrically conductive composition):

A mixture of components of type (C) and (D) was made by mixing 69 pbw of D.E.R.™ 732 from Dow Chemical , 4 pbw of 1-(p-methoxybenzyl) tetrahydrothiophenium hexafluoroantimonate, 21 pbw Araldite® DY-E from Huntsman, and 6 pbw of oleic acid. 17 vol.-% (50 wt.-%) of SF-3J from Ames Goldsmith (particles of (A) type), 24 vol.-% (30 wt.-%) of CL3000SG from Almatis (particles of (B) type) and 59 vol.-% (20 wt.-%) of the mixture of components of type (C) and (D) were mixed. Mixing was performed by introducing the mixture of components (C) and (D) into a beaker and then mixing with the further components by means of a spatula, followed by mixing with a paddle mixer at 300 to 400 U/min for 5 min. Thereafter, the mixtures were milled twice in a triple roll mill at 21 °C, followed by evacuation at less than 10 mbar under stirring with a paddle mixer for 20 min.

### Example 1d (Preparation of an electrically conductive composition):

A mixture of components of type (C) and (D) was made by mixing 63 pbw of Araldite® PY 302-2 from Huntsman, 8 pbw of Curezol® C2E4MZ from Shikoku, 23 pbw Araldite® DY-E from Huntsman, 4 pbw of 4-cyclohexanedimethanol divinylether and 2 pbw of oleic acid.

13 vol.-% (40 wt.-%) of AA-192N from Metalor (particles of (A) type), 31 vol.-% (40 wt.-%) of AE9104 from Admatechs (particles of (B) type) and 56 vol.-% (20 wt.-%) of the mixture of components of type (C) and (D) were mixed. Mixing was performed by introducing the mixture of components (C) and (D) into a beaker and then mixing with the further components by means of a spatula, followed by mixing with a paddle mixer at 300 to 400 U/min for 5 min. Thereafter, the mixtures were milled twice in a triple roll mill at 21 °C, followed by evacuation at less than 10 mbar under stirring with a paddle mixer for 20 min.

### Example 2 (Production of a photovoltaic stack):

The electrically conductive composition of Example 1 was applied to the backside emitter and collector contacts of a MWT solar cell (JACP6WR-0 from JA Solar) via stencil printing in a thickness of 400 µm.

Meanwhile a punched Ebfoil® dielectric layer from Coveme was placed on a conductive backsheet foil (Ebfoil® Backsheet Back-contact from Coveme) to form a stack. Thereafter the solar cell was placed with its backside provided with the electrically conductive composition facing the punched Ebfoil® dielectric layer of the stack. On top of the solar cells frontside a sheet of a Solar Encapsulant Film EVA9100 from 3M™ was placed. A glass sheet (vsol from vetro solar™) was placed on top of the encapsulant film.

The entire stack was then laminated under application of heat and mechanical pressure. First, temperature was increased to 150 °C at a rate of 13 °C/min. At 80 °C a mechanical pressure of 1 bar was applied gently and homogeneously on the top and bottom face of the stack. After 9 minutes at 150 °C the stack was cooled at a rate of 25 °C/min until the stack reached 20 °C. After reaching 80 °C the mechanical pressure was reduced to zero.

## Claims

1. Use of an electrically conductive composition as an electrically conductive adhesive for mechanically and electrically connecting at least one contact of a solar cell with an electrical conductor, wherein said at least one contact is selected from the group consisting of emitter contacts and collector contacts,
**characterized in**
**that** the electrically conductive composition comprises
(A) 2 to 35 vol.-% of silver particles having an average particle size in the range of 1 to 25 µm and exhibiting an aspect ratio in the range of 5 to 30 : 1,
(B) 10 to 63 vol.-% of non-metallic particles having an average particle size in the range of 1 to 25 µm, exhibiting an aspect ratio in the range of 1 to 3 : 1,
(C) 30 to 80 vol.-% of a curable resin system, and
(D) 0 to 10 vol.-% of at least one additive,
wherein the sum of the vol.-% of particles (A) and (B) totals 25 to 65 vol.-%,
wherein the viscosity of the electrically conductive composition is in the range of 4 to 45 Pa·s measured in accordance with DIN 53018 (at 23 °C, CSR-measurement, cone-plate system, shear rate of 50 rounds per second),
wherein the electrically conductive composition is applied to the contact surface of the at least one contact of the solar cell and/or to the contact surface of the electrical conductor to be adhesively bonded to the at least one contact of the solar cell,
wherein the application of the electrically conductive composition is performed by printing, jetting or dispensing, and
wherein average particle size means the mean primary particle diameter (d50) determined by means of laser diffraction..

2. The use of claim 1,
wherein the sum of the vol.-% of (A), (B), (C) and, if present, (D) totals 100 vol.-% of the electrically conductive composition.

3. The use of claim 1 or 2,
wherein the silver particles (A) are particles of pure silver and/or of silver alloy.

4. The use of any one of the preceding claims,
wherein the non-metallic particles (B) are selected from the group consisting of graphite particles, glass particles, ceramics particles, plastics particles, diamond particles, boron nitride particles, silicon dioxide particles, silicon nitride particles, silicon carbide particles, aluminosilicate particles, aluminum oxide particles, aluminum nitride particles, zirconium oxide particles and titanium dioxide particles.

5. The use of any one of the preceding claims,
wherein the silver particles (A) have an average particle size in the range of 0.2 to 2 times the average particle size of the non-metallic particles (B).

6. The use of any one of the preceding claims,
wherein the curable resin system (C) comprises those constituents of the electrically conductive composition which after the application and curing thereof form a covalently crosslinked polymer matrix in which the (A) and (B) particles are embedded.

7. The use of any one of the preceding claims,
wherein the curable resin system (C) comprises self-crosslinkable epoxy resin or a system of epoxy resin and hardener for the epoxy resin selected among polyamine hardeners, polycarboxylic acid hardeners and polycarboxylic acid anhydride hardeners.

8. The use of claim 7,
wherein the curable resin system (C) comprises a system of epoxy resin, polyamine hardener for the epoxy resin and, optionally, lactone.

9. The use of any one of the preceding claims,
wherein after the application of the electrically conductive composition the one or more solar cell contacts and the electrical conductor(s) to be adhesively bonded thereto are put together with their contact surfaces having the electrically conductive composition in between to form an assembly.

10. The use of claim 9,
wherein the electrically conductive composition comprised by the assembly is cured.

11. The use of claim 10,
wherein the curing is thermal curing.

12. The use of claim 11,
wherein the thermal curing is performed in a separate step or takes place in the course of assembling and consolidating a photovoltaic stack.

## Patentansprüche

1. Verwendung einer elektrisch leitfähigen Zusammensetzung als elektrisch leitfähiger Klebstoff zum mechanischen und elektrischen Verbinden mindestens eines Kontaktes einer Solarzelle mit einem elektrischen Leiter, worin der mindestens eine Kontakt ausgewählt ist aus der Gruppe bestehend aus Emitterkontakten und Kollektorkontakten,
**dadurch gekennzeichnet, dass** die elektrisch leitfähige Zusammensetzung
(A) 2 bis 35 Vol.-% Silberpartikel mit einer durchschnittlichen Partikelgröße im Bereich von 1 bis 25 µm umfasst und ein Seitenverhältnis im Bereich von 5 bis 30:1, aufweist,
(B) 10 bis 63 Vol.-% nicht-metallische Partikel mit einer durchschnittlichen Partikelgröße im Bereich von 1 bis 25 µm umfasst, die ein Längenverhältnis im Bereich von 1 bis 3:1 aufweisen,
(C) 30 bis 80 Vol.-% eines aushärtbaren Harzsystems umfasst, und
(D) 0 bis 10 Vol.-% mindestens eines Additivs umfasst,
worin die Summe der Vol.-% der Partikel (A) und (B) insgesamt 25 bis 65 Vol.-% beträgt,
worin die Viskosität der elektrisch leitfähigen Zusammensetzung im Bereich von 4 bis 45 Pa·s liegt, gemessen nach DIN 53018 (bei 23°C, CSR-Messung, Kegel-Platten-System, Scherrate von 50 Schuss pro Sekunde),
worin die elektrisch leitfähige Zusammensetzung auf die Kontaktfläche des mindestens einen Kontakts der Solarzelle und/oder auf die Kontaktfläche des elektrischen Leiters aufgebracht wird, um mit dem mindestens einen Kontakt der Solarzelle verklebt zu werden,
worin das Aufbringen der elektrisch leitfähigen Zusammensetzung durch Drucken, Strahlen oder Dispensieren erfolgt, und
worin die durchschnittliche Partikelgröße den primären Partikeldurchmesser (d50) bedeutet, der mittels Laserbeugung bestimmt wird.

2. Verwendung nach Anspruch 1, worin die Summe der Vol.-% von (A), (B), (C) und, falls vorhanden, (D) 100 Vol.-% der elektrisch leitfähigen Zusammensetzung ergibt.

3. Verwendung nach Anspruch 1 oder 2, worin die Silberpartikel (A) Partikel aus reinem Silber und/oder aus einer Silberlegierung sind.

4. Verwendung nach einem beliebigen der vorangehenden Ansprüche, worin die nicht-metallischen Partikel (B) ausgewählt sind aus der Gruppe bestehend aus Graphitpartikeln, Glaspartikeln, Keramikpartikeln, Kunststoffpartikeln, Diamantpartikeln, Bornitridpartikeln, Siliziumdioxidpartikeln, Siliciumnitridpartikeln, Siliciumcarbidpartikeln, Aluminosilikatpartikeln, Aluminiumoxidpartikeln, Aluminiumnitridpartikeln, Zirkonoxidpartikeln und Titandioxidpartikeln.

5. Verwendung nach einem beliebigen der vorangehenden Ansprüche, worin die Silberpartikel (A) eine mittlere Partikelgröße im Bereich von 0,2 bis 2-mal der durchschnittlichen Partikelgröße der nicht-metallischen Partikel (B) aufweisen.

6. Verwendung nach einem beliebigen der vorangehenden Ansprüche, worin das aushärtbare Harzsystem (C) diejenigen Bestandteile der elektrisch leitfähigen Zusammensetzung umfasst, die nach dem Aufbringen und dem Aushärten derselben eine kovalent vernetzte Polymermatrix bilden, in welche die (A)- und (B)-Partikel eingebettet sind.

7. Verwendung nach einem beliebigen der vorangehenden Ansprüche, worin das aushärtbare Harzsystem (C) ein selbstvernetzendes Epoxidharz oder ein System aus Epoxidharz und einen Härter für das Epoxidharz, ausgewählt aus Polyaminhärtern, Polycarbonathärtern und Polycarbonsäureanhydridhärtern, umfasst.

8. Verwendung nach Anspruch 7, worin das aushärtbare Harzsystem (C) ein System aus Epoxidharz, Polyaminhärter für das Epoxidharz und wahlweise Lacton umfasst.

9. Verwendung nach einem beliebigen der vorangehenden Ansprüche, worin nach dem Aufbringen der elektrisch leitfähigen Zusammensetzung die einen oder mehreren Solarzellenkontakte und der oder die elektrischen Leiter, die daran zu verkleben sind, mit ihren Kontaktflächen, welche die elektrisch leitfähige Zusammensetzung dazwischen aufweisen, zu einer Baugruppe zusammengefügt werden.

10. Verwendung nach Anspruch 9, worin die durch die Baugruppe umfasste elektrisch leitfähige Zusammensetzung ausgehärtet ist.

11. Verwendung nach Anspruch 10, worin das Aushärten ein thermisches Aushärten ist.

12. Verwendung nach Anspruch 11, worin das thermische Aushärten in einem separaten Schritt durchgeführt wird oder im Rahmen der Montage und Konsolidierung eines Photovoltaikstapels erfolgt.

## Revendications

1. Utilisation d'une composition électriquement conductrice comme adhésif électriquement conducteur pour connecter mécaniquement et électriquement au moins un contact d'une cellule solaire à un conducteur électrique, dans laquelle ledit au moins un contact est sélectionné parmi le groupe constitué de contacts émetteurs et de contacts collecteurs,
**caractérisée en ce**
**que** la composition électriquement conductrice comprend
(A) 2 à 35 % en vol. de particules d'argent ayant une taille particulaire moyenne dans la plage de 1 à 25 µm et présentant un rapport de longueur dans la plage de 5 à 30/1,
(B) 10 à 63 % en vol. de particules non métalliques ayant une taille particulaire moyenne dans la plage de 1 à 25 µm, présentant un rapport de longueur dans la plage de 1 à 3/1,
(C) 30 à 80 % en vol. d'un système de résine durcissable, et
(D) 0 à 10 % en vol. d'au moins un additif,
dans laquelle la somme des % en vol. des particules (A) et (B) totalise 25 à 65 % en vol.,
dans laquelle la viscosité de la composition électriquement conductrice est dans la plage de 4 à 45 Pa.s, mesurée conformément à DIN 53018 (à 23°C, mesure CSR, système cône-plan, vitesse de cisaillement de 50 tours par seconde),
dans laquelle la composition électriquement conductrice est appliquée à la surface de contact de l'au moins un contact de la cellule solaire et/ou à la surface de contact du conducteur électrique devant être lié de manière adhésive à l'au moins un contact de la cellule solaire,
dans laquelle l'application de la composition électriquement conductrice est réalisée par impression, injection ou distribution, et
dans laquelle taille particulaire moyenne signifie le diamètre particulaire primaire moyen (d50) déterminé au moyen d'une diffraction laser.

2. Utilisation selon la revendication 1,
dans laquelle la somme des % en vol. de (A), (B), (C) et, le cas échéant, (D) totalise 100 % en vol. de la composition électriquement conductrice.

3. Utilisation selon la revendication 1 ou 2,
dans laquelle les particules d'argent (A) sont des particules d'argent pur et/ou d'alliage d'argent.

4. Utilisation selon l'une quelconque des revendications précédentes,
dans laquelle les particules non métalliques (B) sont sélectionnées parmi le groupe constitué de particules de graphite, particules de verre, particules de céramique, plastiques de plastique, particules de diamant, particules de nitrure de bore, particules de dioxyde de silicium, particules de nitrure de silicium, particules de carbure de silicium, particules d'aluminosilicate, particules d'oxyde d'aluminium, particules de nitrure d'aluminium, particules d'oxyde de zirconium et particules de dioxyde de titane.

5. Utilisation selon l'une quelconque des revendications précédentes,
dans laquelle les particules d'argent (A) ont une taille particulaire moyenne dans la plage de 0,2 à 2 fois la taille particulaire moyenne des particules non métalliques (B).

6. Utilisation selon l'une quelconque des revendications précédentes,
dans laquelle le système de résine durcissable (C) comprend les constituants de la composition électriquement conductrice qui forment après l'application et le durcissement de celle-ci une matrice polymère réticulée par covalence dans laquelle les particules (A) et (B) sont incorporées.

7. Utilisation selon l'une quelconque des revendications précédentes,
dans laquelle le système de résine durcissable (C) comprend une résine époxy pouvant être autoréticulée ou un système de résine époxy et durcisseur pour la résine époxy sélectionné parmi des durcisseurs de polyamine, durcisseurs d'acide polycarboxylique et durcisseurs d'anhydride d'acide polycarboxylique.

8. Utilisation selon la revendication 7,
dans laquelle le système de résine durcissable (C) comprend un système de résine époxy, durcisseur de polyamine pour la résine époxy et, en option, lactone.

9. Utilisation selon l'une quelconque des revendications précédentes,
dans laquelle, après l'application de la composition électriquement conductrice, le ou les contacts de cellule solaire et le(s) conducteur(s) électrique(s) devant être lié(s) de manière adhésive à ceux-ci sont assemblés avec leurs surfaces de contact ayant la composition électriquement conductrice entre elles pour former un assemblage.

10. Utilisation selon la revendication 9,
dans laquelle la composition électriquement conductrice comprise par l'assemblage est durcie.

11. Utilisation selon la revendication 10,
dans laquelle le durcissement est un durcissement thermique.

12. Utilisation selon la revendication 11,
dans laquelle le durcissement thermique est réalisé dans une étape séparée ou a lieu au cours de l'assemblage et de la consolidation d'une pile photovoltaïque.
